# EUROPEAN PATENT APPLICATION

(11) **EP 2 829 636 A1**
(43) Date of publication of application: **28.01.2015**
(21) Application number: 13763593.4
(22) Date of filing: 19.03.2013
(51) Int. Cl.: C23C 14/34, C04B 35/00, H01M 4/525

(54) **OXIDE SINTERED BODY AND SPUTTERING TARGET, AND METHOD FOR MANUFACTURING SAME**

(30) Priority: 21.03.2012 JP 2012064475
(71) Applicant: Kobelco Research Institute , Inc., Kobe-shi Hyogo 651-0073 (JP); Toshima MFG. Co. Ltd., Higashimatsuyama-shi Saitama 355-0036 (JP)
(72) Inventor: TAKETOMI, Yuichi, Hyogo 6768670 (JP); TAO, Yuki, Hyogo 6768670 (JP); KANAMARU, Moriyoshi, Hyogo 6768670 (JP); SAKAI, Kenji, Higashimatsuyama-shi Saitama 355-0036 (JP); HASEYAMA, Shuetsu, Higashimatsuyama-shi Saitama 355-0036 (JP); KIKUYAMA, Hideshi, Higashimatsuyama-shi Saitama 355-0036 (JP)
(74) Representative: Müller-Boré & Partner Patentanwälte PartG mbB
(86) International application number: PCT/JP2013/057879
(87) International publication number: WO 2013/141254

(57) **Abstract**

The Li-containing transition metal oxide sintered compact of the present invention includes Li and a transition metal, and further includes Al, Si, Zr, Ca, and Y as impurity elements, of which contents are controlled to the following ranges: Al ≤ 90 ppm; Si ≤ 100 ppm; Zr ≤ 100 ppm; Ca ≤ 80 ppm; and Y ≤ 20 ppm, wherein the sintered compact has a relative density of 95% or higher and a specific resistance of lower than 2 x 10⁷ Ω cm. The present invention makes it possible to stably form Li-containing transition metal oxide thin films useful as the positive electrode thin films of secondary batteries or the like at a high deposition rate without causing abnormal discharge.

## Description

### TECHNICAL FIELD

The present invention relates to an oxide sintered compact and a sputtering target to be used when Li-containing transition metal oxide thin films are formed by a sputtering method, which metal oxides are useful as the positive electrode active materials of all-solid type secondary batteries or the like. More particularly, the present invention relates to a Li-containing transition metal oxide sintered compact and a sputtering target, which make it possible to stably form the thin films at a high deposition rate by a sputtering method, as well as processes for producing the oxide sintered compact.

### BACKGROUND ART

Li-based thin film secondary batteries are used for various devices such as thin film solar cells, thin film thermoelectric elements, and wireless charging elements, and their demand has grown rapidly. A typical example of the Li-based thin film secondary batteries is formed of a positive electrode, a Li-containing solid electrolyte, and a negative electrode, in which the positive electrode is made of a Li-containing transition metal oxide thin film containing Li and a transition metal, and the negative electrode is made of a Li metal thin film or the like.

For the formation of Li-containing transition metal oxide thin films, a sputtering method has preferably been used, in which a sputtering target (hereinafter sometimes abbreviated as a target) to be used for sputtering is made of the same material as that of such films. The sputtering method has advantages such that film forming conditions can easily be adjusted and film formation can easily be made on semiconductor substrates. However, it has problems such as abnormal discharge (arcing) or discharge marks produced by arc discharge in the film formation by sputtering, thereby making it impossible to attain stable discharge, resulting in the occurrence of cracks or nodules during the sputtering. These are mainly due to low relative density of the sputtering target.

To solve these problems, for example, Patent Document 1 discloses a Li-containing transition metal oxide target having a relative density of 90% or higher and an average crystal grain size of 1 µm to 50 µm. Patent Document 1 teaches using a Li-containing transition metal salt as the raw material (precursor), which transition metal salt has a Li/transition metal mole ratio controlled to a prescribed range, thereby making it possible to remove a composition shift between the target and the thin films after the film formation.

### PRIOR ART DOCUMENTS

### PATENT DOCUMENTS

Patent Document 1: Pamphlet of International Publication WO2008/012970

### SUMMARY OF THE INVENTION

### PROBLEMS TO BE SOLVED BY THE INVENTION

In general, targets to be used in a sputtering method, and further, sintered compacts for producing targets, or oxide sintered compacts in the present invention, are required to have relative density as high as possible and specific resistance as low as possible. This is because targets fulfilling both the requirements can solve the problems during sputtering as described above, i.e., problems such as occurrence of abnormal discharge, thereby making it impossible to attain stable film formation. The use of a target having high relative density can increase film formation power during sputtering, thereby improving deposition rate, resulting in the enhancement of productivity. The use of a target having lowered specific resistance can enhance power during RF (radio frequency) sputtering, thereby making it possible to use the target even for DC (direct current) sputtering, resulting in the further improvement of deposition rate.

Further, to make favorable the characteristics of a thin film, or a positive electrode thin film in the present invention, obtained using a target, the impurity content of the positive electrode thin film is preferred as low as possible, for which purpose it has strongly been desired to provide a target and an oxide sintered compact, having impurity content as low as possible.

The present invention has been completed, taking into consideration such situation, and it is intended to provide a Li-containing transition metal oxide sintered compact and an oxide sintered compact target; as well as processes for producing the oxide sintered compact, which oxide sintered compact makes it possible to stably form Li-containing transition metal oxide thin films useful as the positive electrode thin films of secondary batteries or the like at a high deposition rate without causing abnormal discharge, and which oxide sintered compact has high relative density, low specific resistance, and low impurity content.

### MEANS FOR SOLVING THE PROBLEMS

The oxide sintered compact of the present invention, which can solve the above problems, comprises Li and a transition metal, and further comprises Al, Si, Zr, Ca, and Y as impurity elements, of which contents are controlled to the following ranges:
Al ≤ 90 ppm (where the term "ppm" means "ppm by mass" and the same shall apply hereafter);
Si ≤ 100 ppm;
Zr ≤ 100 ppm;
Ca ≤ 80 ppm; and
Y ≤ 20 ppm,
wherein the oxide sintered compact has a relative density of 95% or higher and a specific resistance of lower than 2 x 10⁷ Ω cm.

In a preferred embodiment of the present invention, the transition metal is at least one selected from the group consisting of Co, Mn, Fe, and Ni.

The present invention further includes a sputtering target obtained using an oxide sintered compact as described above.

In addition, the process for producing an oxide sintered compact as described above (hereinafter referred to as the first production process), which can solve the above problems, comprises:
sintering a raw material including a Li oxide and a transition metal oxide by a hot press method using a graphite mold; and
subsequently performing heat treatment of the resultant sintered material in an oxygen-containing atmosphere until the sintered material has a specific resistance of lower than 2 x 10⁷ Ω cm.

In a preferred embodiment of the present invention, the heat treatment is performed at a temperature of 300°C to 1200°C.

In a preferred embodiment of the present invention, the sintering by a hot press method is performed in an inert atmosphere at a temperature of 700°C to 1000°C under a pressure of 10 to 100 MPa.

Further, the process for producing an oxide sintered compact as described above (hereinafter referred to as the second production process), which can solve the above problems, comprises:
sintering a raw material including a Li oxide and a transition metal oxide in an oxygen-containing atmosphere by a hot press method using a ceramic mold.

In a preferred embodiment of the present invention, the sintering by a hot press method is performed at a temperature of 700°C to 1000°C under a pressure of 10 to 100 MPa.

### EFFECTS OF THE INVENTION

The present invention makes it possible to provide a Li-containing transition metal oxide sintered compact and an oxide sintered compact target, having high relative density, low specific resistance, and low impurity content. Therefore, Li-containing transition metal oxide thin films useful as the positive electrode thin films of secondary batteries or the like can stably be formed at a high deposition rate without causing abnormal discharge.

### MODE FOR CARRYING OUT THE INVENTION

The present inventors have made various studies for providing a Li-containing transition metal oxide sintered compact and an oxide sintered compact target (hereinafter sometimes referred to simply as a target), having high relative density, low specific resistance, and low impurity content. As a result, they have found that the intended purpose can be attained by adopting:
(A) as the first process, the process in which a raw material including a Li oxide and a transition metal oxide is sintered, for example, in an inert atmosphere at a temperature of 700°C to 1000°C under a pressure of 10 to 100 MPa, by a hot press method using a graphite mold, and heat treatment of the resultant sintered material is subsequently performed, for example, at a heat treatment temperature of 300°C to 1200°C, in an oxygen-containing atmosphere until the sintered material has a specific resistance of lower than 2 x 10⁷ Ω cm; or
(B) as the second process, the process in which a raw material including a Li oxide and a transition metal oxide is sintered, for example, at a temperature of 700°C to 1000°C under a pressure of 10 to 100 MPa, in an oxygen-containing atmosphere by a hot press method using a ceramic mold.

The following will describe each of the production processes.

### First production process

The first production process comprising: sintering a prescribed raw material by a hot press method using a graphite mold, and subsequently performing heat treatment in an oxygen-containing atmosphere until a prescribed specific resistance can be attained.

The following will describe the details for arriving at the first production process.

First, it is important in the present invention that the sintering is performed by a hot press method using a graphite mold. This is because the lowering of impurities and the improvement of relative density are mainly taken into consideration. In other words, a conventional normal pressure sintering method requires adding a binder for molding a raw material in a mold. For the addition of a binder or the like, balls for mixing or the like are usually used, but there is a fear that impurities may be mixed from balls for mixing, so that the lowering of impurities has a limitation. As the balls for mixing, alumina balls, zirconia balls, or silicon nitride balls may be used, from which alumina, zirconia, silicon, or yttrium may be mixed in as impurities. In addition, the normal pressure sintering method cannot provide a sintered compact having high relative density similarly to that of a sintered compact obtained by a hot press.

Thus, to solve the above problem, a hot press method using a graphite mold was adopted. In the hot press method, sintering can be performed directly by a hot press without adding any binder for molding, and therefore, it has no fear of impurity incorporation arising from balls for mixing, and in addition, it can attain high relative density that cannot be attained by an ordinary pressure sintering method.

For the conditions of sintering by the hot press method, sintering is recommended, for example, in an inert atmosphere such as nitrogen or argon atmosphere at a temperature of 700°C to 1000°C under a pressure of 10 to 100 MPa. The reason for the inert atmosphere is that it can suppress the oxidation or vanishment of graphite forming a graphite mold to be used in the present invention.

However, it was found that just sintering by a hot press using a graphite mold cannot attain both high relative density and low specific resistance as intended in the present invention and the above sintering can make the resultant sintered compact higher in relative density up to 95% or higher but rather higher in specific resistance up to 2 x 10⁷ Ω cm or higher. In short, it was found that the above sintering cannot attain the lowering of specific resistance additionally, even if the above sintering can attain the lowering of impurities in a sintered compact and an increase of relative density.

The present inventors have therefore investigated the reasons and have eventually found that a hot press method using a graphite mold causes the reduction of an oxide sintered compact by the presence of graphite, thereby increasing specific resistance. Taking into consideration that oxide sintered compacts such as InGaZnO (IGZO), which is used as an oxide semiconductor of display devices, even among oxides, have lowered specific resistance by reduction, the above finding was unexpected.

For Li- and transition metal-containing oxide sintered compacts intended in the present invention, the reason of increasing specific resistance in contrast to IGZO described above is not known in detail, but is supposed as follows: In Li- and transition metal-containing oxide sintered compacts, Li ions take charge of exhibiting conductivity, and therefore, the occurrence of crystal lattice distortion by reduction seems to inhibit the movement of Li ions in the crystal lattices, thereby increasing specific resistance.

Thus, further studies have been made to suppress an increase in the specific resistance of a sintered compact by a hot press using a graphite mold in an inert atmosphere, and as a result, it was unexpectedly found that the specific resistance is remarkably lowered when the heating treatment of the sintered compact is performed in an oxygen-containing atmosphere. The reason is not known in detail, but is supposed to be that the reintroduction of oxygen can remove crystal lattice distortion to make the movement of Li ions smooth.

The following will describe the first production process in detail according to the order of steps.

### Raw material

As the raw material, a composite oxide containing Li and a transition metal is used in powder form. The Al, Si, Zr, Ca, and Y impurity contents of the powder are equal to, or smaller than, the contents allowed when the raw material is formed into a sintered compact: Al ≤ 90 ppm, Si ≤ 100 ppm, Zr ≤ 100 ppm, Ca ≤ 80 ppm, and Y ≤ 20 ppm. In the present invention, however, the raw material is treated not to have these impurities in the subsequent step, and therefore, there is no need to use any special material as the above composite oxide containing Li and a transition metal in powder form, but commercially available products with high purity can be used without any treatment.

### Sintering by hot press method using graphite mold

The raw material powder is filled into a graphite mold. In the filling into the graphite mold, the raw material powder may directly be filled without any performing, or may be filled once into another mold and then preformed with a mold press, after which the perform may be filled into the graphite mold. The latter performing is performed for the purpose of improving the handling properties when the perform is set to a prescribed mold in the hot press step, and the raw material may preferably be made into a perform by the application of a pressure of about 0.5 to 1.0 tonf/cm².

The conditions of hot press sintering may preferably be controlled to a temperature of 700°C to 1000°C under a pressure of 10 to 100 MPa in an inert atmosphere. When the sintering temperature is lower than 700°C, the relative density of a sintered compact become as low as less than 95%, e.g., about 74% in one Example below. On the other hand, when the sintering temperature is higher than 1000°C, a weight loss by sintering becomes prominent, and a desired relative density as high as 95% or higher cannot be attained, e.g., about 90% in one Example below. The sintering temperature may preferably be 800°C to 950°C.

Similarly, when the pressure in the sintering is lower than 10 MPa, the relative density of a sintered compact becomes lowered, thereby making it impossible to attain a desired high relative density. On the other hand, when the pressure in the sintering is higher than 100 MPa, problems will arise, such as damage in the form of a graphite mold, thereby making it difficult to perform hot pressing. The pressure may preferably be 20 to 50 MPa.

In the sintering, the sintered compact may be retained when reached the maximum temperature range. The retention time at that time may vary depending upon the temperature and pressure in the sintering, but may preferably be about 100 hours or shorter. When the retention time is longer than 100 hours, a weight loss by sintering will become prominent, thereby making it impossible to obtain a favorable sintered compact, i.e., a sintered compact having high relative density and low specific resistance. The retention time may include zero (0) hour, i.e., no retention, and for example, when the sintering temperature is set to the optimum range in relation to the raw material or others, the retention time may be set to zero (0) hour.

As the gas to be used in an inert atmosphere, there can be mentioned, for example, inert gases such as Ar and N₂. The atmosphere control method is not particularly limited, but the atmosphere may be adjusted by, for example, introducing Ar gas or N₂ gas into a furnace.

### Heating treatment after sintering

Then, the sintered compact is heat treated in an oxygen-containing atmosphere until it has prescribed characteristics, i.e., until the specific resistance of a sintered material becomes lower than 2 x 10⁷ Ω cm. The oxygen-containing atmosphere may include an atmosphere containing oxygen at a volume ratio of 20% or higher, a typical example of which is the case of heating in the air, and may preferably be an atmosphere containing oxygen at a volume ratio of 50% or higher, and particularly preferably at a volume ratio of 80% or higher.

The heating treatment is important to perform heating in an oxygen-containing atmosphere to attain the desired characteristics, and specific heat treatment conditions may appropriately be controlled in relation to the kind of raw material to be used, the size of a sintered compact, the volume of a sintered compact to be heat treated at one time, and others. For example, heat treatment is recommended in a temperature range of 300°C to 1200°C for about 1 minute to 100 hours. When the heat treatment temperature is lower than 300°C, the specific resistance will remain high as it is after the sintering, e.g., in about 10⁸ Ω cm level, thereby making it impossible to attain low specific resistance. On the other hand, when the heat treatment temperature is higher than 1200°C, a weight loss by sintering will become prominent, thereby making it impossible to obtain a favorable sintered compact.

The heating time may preferably be about 100 hours or shorter. When the heating time is longer than 100 hours, a weight loss will become prominent, thereby making it impossible to obtain a favorable sintered compact. The lower limit of the heating time is not particularly limited, but, for example, when the heating temperature is set to the optimum range, the heating time may be set even to about 1 minute.

More specifically, the heating time may preferably be controlled in an appropriate manner in relation to the heating temperature until desired low specific resistance can be attained. As a general tendency, higher hearting temperature or longer heating time tends to provide lowered specific resistance. Therefore, when the heating temperature is higher, the heating time can be set shorter, whereas when the heating temperature is lower, the heating time may preferably be set longer. As demonstrated in Examples below, for example, when the heating temperature is as low as about 300°C, the heating time may preferably be set longer, e.g., 9 hours or longer in Examples. On the other hand, when the heating temperature is relatively high, it becomes to attain low specific resistance regardless of the heating time. In Examples below, for example, when the heating temperature is 600°C to 1200°C, low specific resistance can be attained even by heating for only 1 minute.

The oxide sintered compact obtained as described above contains prescribed impurity elements lowered to the ranges as defined in the present invention, and satisfies a relative density of 95% or higher and a specific resistance of lower than 2 x 10⁷ Ω cm.

Further, the oxide sintered compact is subjected to conventional machining and bonding, thereby obtaining the sputtering target of the present invention. The resultant sputtering target has the same and extremely favorable impurity contents, relative density, and specific resistance as those of the oxide sintered compact.

### Second production process

The second production process comprises sintering a prescribed raw material in an oxygen-containing atmosphere by a hot press method using a ceramic mold. Comparing the second production process with the first production process, both the processes mutually coincide with each other in that the sintering is performed by a hot press method. The sintering by a hot press in the first production process is performed using a graphite mold in an inert atmosphere and such sintering is followed by heating treatment in an oxygen atmosphere, i.e., the first production process has both hot press sintering using a graphite mold in an inert atmosphere and subsequent heating treatment in an oxygen atmosphere. In contrast, the sintering by a hot press in the second production process is performed using a ceramic mold in an oxygen-containing atmosphere and such sintering is not followed by heating treatment, i.e., the second production process has only hot press sintering in an oxygen atmosphere but no subsequent heating treatment.

The following will describe only the differences from the first production process.

### Sintering by hot press method using ceramic mold

In the second production process, the reason for sintering in an oxygen-containing atmosphere is to suppress the reduction of a sintered compact. As a specific gas composition, for example, air atmosphere can be used.

Since the sintering is performed in an oxygen-containing atmosphere as described above, a graphite mold should be substituted by a ceramic mold. As the ceramic material, for example, alumina, zirconia, silicon nitride, and silicon carbide can be used.

In the second production process, the other hot press sintering conditions, except that only the atmosphere condition is controlled as described above, are the same as those of the first production process. Thus, it only needs to make reference to the first production process for temperature, pressure, and retention time at the maximum temperature.

According to the second production process, only sintering by a hot press can attain prescribed relative density, not to mention relative density, and therefore, no heat treatment is required after the sintering.

The oxide sintered compact obtained as described above contains prescribed impurity elements lowered to the ranges defined in the present invention, and satisfies a relative density of 95% or higher and a specific resistance of lower than 2 x 10⁷ Ω cm.

The sputtering target obtained using the oxide sintered compact also has the same and extremely favorable impurity contents, relative density, and specific resistance as those of the oxide sintered compact.

### Li-containing transition metal oxide sintered compact of the present invention

The following will describe the Li-containing transition metal oxide sintered compact of the present invention. The oxide sintered compact of the present invention is obtained by the first or second production process, wherein Al, Si, Zr, Ca, and Y as impurities are controlled to the following ranges: Al ≤ 90 ppm, Si ≤ 100 ppm, Zr ≤ 100 ppm, Ca ≤ 80 ppm, and Y ≤ 20 ppm, and wherein the oxide sintered compact satisfies a relative density of 95% or higher and a specific resistance of lower than 2 x 10⁷ Ω cm.

The transition metal may preferably be at least one selected from the group consisting of Co, Mn, Fe, and Ni. These may be used alone or in combination. Among these, Co is more preferred.

The impurity element contents may preferably be as low as possible, and may preferably be, for example, Al ≤ 60 ppm, Si ≤ 60 ppm, Zr ≤ 60 ppm, Ca ≤ 60 ppm, and Y ≤ 15 ppm.

The oxide sintered compact may preferably have a specific resistance as low as possible, in a preferred order of lower than 1.0 x 10⁷ Ω cm, lower than 1.0 x 10⁶ Ω cm, lower than 1.0 x 10⁶ Ω cm, lower than 1.0 x 10⁴ Ω cm, and lower than 1.0 x 10³ Ω cm. Lower specific resistance can suppress abnormal discharge, thereby making it possible to further suppress abnormal discharge during the sputtering, so that a sputtering method using a sputtering target can be performed with high efficiency in a production line of secondary batteries or the like.

The oxide sintered compact may be better to have a relative density as high as possible, in a preferred order of 97% or higher, 98% or higher, 99% or higher, and 99.9% or higher. Higher relative density can prevent the occurrence of cracks or nodules during the sputtering, thereby making it possible to keep stable discharge continuously to the end of target's life.

The oxide sintered compact may preferably have a crystal grain size, i.e., an equivalent circle diameter, of about 1 to 40 µm. This results in that uniform thin films can easily be formed with the lowering of defects such as particles.

### Sputtering target

The present invention further includes a sputtering target obtained using the oxide sintered compact, i.e., an oxide sintered compact target, in its scope. The process for producing the sputtering target is not particularly limited, but ordinarily available processes may be used. The resultant sputtering target may also have the same characteristics as those of the oxide sintered compact, including high relative density, low specific resistance, and lowering of prescribed impurity elements.

The present application claims the benefit of priority based on Japanese Patent Application No. 2012-064475 filed on March 21, 2012, of which disclosure is incorporated by reference herein in its entirety.

### EXAMPLES

The present invention will hereinafter be described more specifically by way of Examples, but the present invention is not limited to the following Examples. The present invention can be put into practice after appropriate modifications or variations are added within a scope adaptable to the spirit of the present invention, all of which are included in the technical scope of the present invention.

### Preparation of oxide sintered compacts

As the raw material powder, commercially available LiCoO₂ powder was used, which powder was a fine particle material having a purity of 99.99% or higher and an average particle size of 10 µm or smaller. The raw material powder was quantitatively analyzed for impurity contents using an ICP emission spectrometric apparatus, model "ICP-8000" available from Shimadzu Corporation, and it was found that the impurity content was about 15 to 30 ppm for Al, each lower than 60 ppm for Si, Zr, and Ca, and lower than 20 ppm for Y.

Then, the raw material was directly set in a mold, and sintered with a hot press under the conditions shown in Table 1, thereby obtaining an oxide sintered compact. Nos. 1 to 5 in Table 1 are examples of the oxide sintered compact obtained by the first production process using a graphite mold. On the other hand, Nos. 6 to 8 are examples of the oxide sintered compact by the second production process using a ceramic mold made of alumina. In Nos. 6 to 8, air was used as the atmospheric gas, and the volume fraction of oxygen was 20%.

For reference, oxide sintered compacts as described above were prepared by a conventional normal pressure sintering method.

More specifically, 1 g of polyvinyl alcohol as the molding binder was added to 100 g of the same LiCoO₂ raw material powder as described above, to which 361 mL of acetone was added, and these materials were mixed by means of alumina balls. Then, the mixture was dried in a stainless steel vat, and passed though a nylon mesh having a pore size of 200 µm, thereby obtaining a granulated powder having a particle size smaller than 200 µm.

The resultant granulated powder was preformed by a mold press under a forming pressure of 10 ton/cm² into a size of 110 mm x 160 mm x 13 mm in t, where t is thickness, after which the preform was heated to 500°C in an air atmosphere and retained at the same temperature for 5 hours to achieve degreasing. The resultant compact was sintered in air under the conditions shown in Table 2, thereby obtaining an oxide sintered compact.

### Impurity element content measurement of oxide sintered compacts

The oxide sintered compacts obtained by the processes shown in Table 1 and 2 were each quantitatively analyzed for impurity element contents using an ICP emission spectrometric apparatus, model "ICP-8000" available from Shimadzu Corporation.

### Relative density measurement of oxide sintered compacts

The oxide sintered compacts obtained as described above were each measured for relative density by the Archimedes method.

These results are shown together in Tables 1 and 2. In these tables, only Al content was described as an impurity element, but for the other impurity elements, i.e., Si, Zr, Ca, and Y, as specified in the present invention, each element content of any oxide sintered compact falls within the range specified in the present invention. More specifically, the impurity content was lower than 60 ppm for any of Si, Zr, and Ca, and lower than 20 ppm for Y (not shown in the tables).

**[Table 1]**

| No. | Note | Hot press (HP) sintering conditions | | | | Sintered compact | |
|---|---|---|---|---|---|---|---|
| | | Atmosphere | Temperature (°C) | Retention time (hr) | Surface pressure (MPa) | Al content (ppm) | Relative density (%) |
| 1 | First process | N₂ | 650 | 5 | 29.4 | 16 | 74.0 |
| 2 | | N₂ | 750 | 3 | 29.4 | 22 | 95.2 |
| 3 | | N₂ | 850 | 2 | 29.4 | 20 | 97.9 |
| 4 | | N₂ | 950 | 0.5 | 29.4 | 21 | 99.9 |
| 5 | | N₂ | 1050 | 0.5 | 29.4 | 27 | 89.2 |
| 6 | Second process | O₂-containing | 750 | 3 | 29.4 | 24 | 96.1 |
| 7 | | O₂-containing | 850 | 0.5 | 29.4 | 15 | 99.2 |
| 8 | | O₂-containing | 950 | 1.5 | 29.4 | 26 | 98.4 |

**[Table 2]**

| No. | Note | Sintering conditions | | | Sintered compact | |
|---|---|---|---|---|---|---|
| | | Atmosphere | Temperature (°C) | Retention time (hr) | Al content (ppm) | Relative density (%) |
| 9 | conventional method | Air | 1050 | 2 | 120 | 78.5 |
| 10 | | Air | 1200 | 2 | 280 | 82.3 |

The following discussion can be made from Tables 1 and 2.

First, Nos. 2 to 4 in Table 1 are oxide sintered compacts produced by the first production process specified in the present invention; and Nos. 6 to 8 in Table 1 are oxide sintered compacts produced by the second production process specified in the present invention. In all cases where any of the production processes was used, the contents of impurity elements specified in the present invention were lowered to the prescribed ranges and high relative density was achieved.

In contrast, the oxide sintered compacts of Nos. 1 and 5 in Table 1, which were obtained by the first production process, have lowered relative density because of lower sintering temperature in No. 1 and higher sintering temperature in No. 5.

In addition, No. 9, in which the sintering temperature was 1050°C, and No. 10, in which the sintering temperature was 1200°C, in Table 2 are examples of the oxide sintered compact produced by a conventional normal pressure sintering method. In both cases, the oxide sintered compacts had raised Al content and lowered relative density.

### Measurement of specific resistance after heat treatment

Then, the oxide sintered compact of No. 3 in Table 1 was used for heat treatment in an air atmosphere under various conditions shown in Table 3, followed by measurement of specific resistance. The specific resistance was measured by a four-terminal method. For comparison, the oxide sintered compact having undergone completely no heat treatment was also measured for specific resistance.

These results are shown together in Table 3. The oxide sintered compact having undergone completely no heat treatment had a specific resistance of 1.23 x 10⁹ Ω cm (not shown in Table 3).

**[Table 3]**

| Heat treatment condition | Specific resistance after heat treatment (in units of Ω cm) | | | | | | |
|---|---|---|---|---|---|---|---|
| | 1 min | 5 hr | 7 hr | 9 hr | 11 hr | 13 hr | 15 hr |
| 300 | 9.7 x 10⁸ | 8.6 x 1.0⁷ | 5.3 x 107 | 6.3 x 10⁶ | 1.4 x 106 | 1.4 x 10⁶ | 1.4 x 10⁶ |
| 600 | 1.3 x 10⁷ | 9.9 x 10⁵ | 7.6 x 10⁵ | 5.2 x 10⁵ | 3.2 x 105 | 2.5 x 10⁵ | 2.5 x 10⁵ |
| 900 | 2.1 x 10⁶ | 1.4 x 105 | 5.5 x 10⁴ | 7.3 x 103 | 1.8 x 10³ | 3.4 x 10² | 2.5 x 102 |
| 1200 | 9.5 x 102 | 7.5 x 102 | 6.6 x 10² | 5.2 x 10² | 3.1 x 10² | 2.5 x 10² | 2.5 x 10² |

From Table 3, it was found that the oxide sintered compacts having undergone heat treatment at a temperature of 600 to 1200°C were able to have specific resistance lowered to a prescribed level regardless of heating time.

In contrast, it was found that the oxide sintered compact having undergone no heat treatment had raised specific resistance (not shown in the table), thereby making it impossible to ensure the desired characteristics.

In the case where the oxide sintered compact was heated at 300°C, specific resistance became raised when heating time was 9 hours or longer, but desired low specific resistance was obtained when heating time was 7 hours or shorter. Therefore, when heating temperature is low, it is found to be effective to control heating temperature and heating time appropriately.

### Preparation of sputtering target

Then, among the sintered compact having undergone heat treatment as described above, the sintered compact having undergone heat treatment at 900°C for 5 hour (hereinafter referred to as sintered compact A) and the sintered compact having undergone heat treatment at 900°C for 11 hours (hereinafter referred to as sintered compact B), both of which sintered compacts A and B have high relative density, low specific resistance, and lowered impurity element contents, and for comparison, the oxide sintered compact having undergone no heat treatment (hereinafter referred to as sintered compact C) were used to produce sputtering targets. The sputtering targets were obtained by mechanical working of each of the sintered compacts into a size of 4 inch in diameter by 5 mm in thickness and bonding with indium on a Cu-made backing plate. The sputtering targets obtained using sintered compacts A, B, and C will hereinafter be referred to as targets A, B, and C, respectively.

Then, targets A, B, and C were used to make an experiment of film formation as described below.

Film forming apparatus: DC magnetron sputtering apparatus was used.

Film forming conditions: The substrate temperature was 500°C; the DC discharge power was 160 W; the sputtering gas pressure was 3 mTorr; a mixed gas of Ar and oxygen was used as the sputtering gas; and the films were formed to have a thickness of 500 nm.

### Film forming procedures:

Each of the targets was mounted on the sputtering apparatus, and a glass substrate was placed on a substrate stage opposite to the target. The inside of a chamber was made to the vacuum at a pressure of 5 x 10⁻⁴ Pa or lower by a vacuum pump, and the substrate stage was heated to control the substrate temperature to 500°C. Then, the sputtering gas was fed to the inside of the chamber using a mass flow. The sputtering gas pressure was adjusted to 3 mTorr, and a high voltage was applied to the target using a DC (direct current) power supply to cause plasma discharge. The discharge power was adjusted to 160 W, and a film was formed to have a thickness of 500 nm.

As a result, target C having undergone no heat treatment was not able to attain stable DC discharge during the film formation to maintain its continuously discharging state. In addition, numerous discharge marks, which were considered to be due to arc discharge, occurred on the surface of target C.

In contrast, sintered compacts A and B having undergone prescribed heat treatment, i.e., heat treatment at 900°C for 5 hours or heat treatment at 900°C for 11 hours, respectively, were able to attain stable DC discharge during the film formation.

The above results confirmed that the use of oxide sintered compacts and sputtering targets fulfilling the requirement of the present invention makes it possible to stably form Li- and transition metal-containing oxide thin films, which are useful, for example, as positive electrode thin films of Li-based secondary batteries, without causing abnormal discharge or any other trouble by a sputtering method. Therefore, the present invention is extremely useful from the viewpoint that the thin films can be provided with high energy density and high deposition rate by the use of sputtering targets as described above.

## Claims

1. An oxide sintered compact comprising Li and a transition metal, and further comprising Al, Si, Zr, Ca, and Y as impurity elements, of which contents are controlled to the following ranges:
Al ≤ 90 ppm (where the term "ppm" means "ppm by mass" and the same shall apply hereafter);
Si ≤ 100 ppm;
Zr ≤ 100 ppm;
Ca ≤ 80 ppm; and
Y ≤ 20 ppm,
wherein the Li-containing transition metal oxide sintered compact has a relative density of 95% or higher and a specific resistance of lower than 2 x 10⁷ Ω cm.

2. The oxide sintered compact according to claim 1, wherein the transition metal is at least one selected from the group consisting of Co, Mn, Fe, and Ni.

3. A sputtering target obtained using an oxide sintered compact according to claim 1.

4. A process for producing an oxide sintered compact according to claim 1, comprising:
sintering a raw material including a Li oxide and a transition metal oxide by a hot press method using a graphite mold; and
subsequently heat treating the resultant sintered material in an oxygen-containing atmosphere until the sintered material has a specific resistance of lower than 2 x 10⁷ Ω cm.

5. The production process according to claim 4, wherein the heat treatment is performed at a temperature of 300°C to 1200°C.

6. The production process according to claim 4, wherein the sintering by a hot press method is performed in an inert atmosphere at a temperature of 700°C to 1000°C under a pressure of 10 to 100 MPa.

7. A process for producing an oxide sintered compact according to claim 1, comprising:
sintering a raw material including a Li oxide and a transition metal oxide in an oxygen-containing atmosphere by a hot press method using a ceramic mold.

8. The production process according to claim 7, wherein the sintering by a hot press method is performed at a temperature of 700°C to 1000°C under a pressure of 10 to 100 MPa.
